(19) Europäisches Patentamt
European Patent Office
Office européen des brevets

(11) **EP 3 146 568 B1**

(12) **EUROPÄISCHE PATENTSCHRIFT**

(45) Veröffentlichungstag und Bekanntmachung des Hinweises auf die Patenterteilung:
**11.07.2018   Patentblatt 2018/28**

(21) Anmeldenummer: **15724976.4**

(22) Anmeldetag: **19.05.2015**

(51) Int Cl.:
*H01L 27/144* (2006.01)

(86) Internationale Anmeldenummer:
**PCT/EP2015/060969**

(87) Internationale Veröffentlichungsnummer:
**WO 2015/177129 (26.11.2015 Gazette 2015/47)**

(54) **UV-LICHT-SENSOR MIT STREULICHTUNTERDRÜCKUNG UND VERFAHREN ZUR DETEKTION VON UV-LICHT**

UV LIGHT SENSOR WITH STRAY LIGHT SUPPRESSION, AND A METHOD FOR DETECTING UV LIGHT

CAPTEUR DE LUMIÈRE UV À SUPPRESSION DE LUMIÈRE DIFFUSÉE ET PROCÉDÉ DE DÉTECTION DE LUMIÈRE UV

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.05.2014   DE 102014107062**

(43) Veröffentlichungstag der Anmeldung:
**29.03.2017   Patentblatt 2017/13**

(73) Patentinhaber: **IDT Europe GmbH**
**01109 Dresden (DE)**

(72) Erfinder:
• REICHEL, Thomas
  01277 Dresden (DE)
• SCHIFFNER, Lutz
  01465 Langebrück (DE)
• GARZAROLLI, Matthias
  01309 Dresden (DE)
• SÄNDIG, Matthias
  01471 Grossdittmannsdorf (DE)
• GÖPFERT, Lars
  01279 Dresden (DE)

(74) Vertreter: **Lippert Stachow Patentanwälte Rechtsanwälte Partnerschaft mbB**
**Krenkelstrasse 3**
**01309 Dresden (DE)**

(56) Entgegenhaltungen:
EP-A1- 1 646 088        US-A1- 2006 197 097
US-A1- 2007 187 794    US-A1- 2010 178 018
US-B1- 6 821 810

**Beschreibung**

Die Erfindung betrifft einen UV-Licht-Sensor, hergestellt mit einem CMOS-Prozess, umfassend ein Substrat mit einer Oberfläche, einen oder mehrere eine Strahlung detektierende Sensorelemente, die in dem Substrat ausgebildet sind, mindestens einer über der Oberfläche des Substrates angeordneten Passivierungsschicht, sowie einer über der Passivierungsschicht angeordneten Funktionsschicht, wobei die Funktionsschicht als mindestens ein Filter ausgebildet ist. Das Dokument US2007/187794A beschreibt Licht-Sensoren. Die Erfindung betrifft weiterhin ein Verfahren zur Detektion von UV-Licht mit einem UV-Licht-Sensor, wobei das eine oder die mehreren Sensorelemente Licht detektieren und im Ansprechen darauf ein Signal liefern.

UV-Sensoren (ultraviolette Strahlung detektierende Sensoren) finden in einer Vielzahl von Produkten Anwendung, wobei die Sensoren sowohl als einzelne UV-empfindliche Fotodioden (Einelement-Fotodioden) als auch in integrierten, Auswerte- und Steuereinheiten umfassende Schaltungen (ICs) zum Einsatz kommen. Zu den dominierenden Einsatzgebieten zählen die Wasserentkeimung, die Medizintechnik, sowie UV-Curing und die Flammendetektion. In der Medizintechnik werden die UV-Sensoren beispielsweise zur Bestimmung des Sauerstoffgehaltes im Blut und der Pulsfrequenz verwendet. Ein weiterer wichtiger Anwendungsbereich ist die Ermittlung des UV-Index und der Umgebungshelligkeit. Bei dieser Anwendung wird der UV-Anteil der Sonnenstrahlung gemessen und dem Nutzer mitgeteilt, wenn dieser einen über der empfohlenen Tagesdosis liegenden Grenzwert erreicht. Vor allem für zu Sonnenbrand neigenden Personen oder Personen mit empfindlicher Haut können UV-Index messende Sensoren frühzeitig einen Warnhinweis geben. Der UV-Index ist eine Zahl, welche linear von der Intensität des auf die Erde treffenden Sonnenlichts abhängig ist und durch die Weltgesundheitsorganisation (WHO) standardisiert wurde.

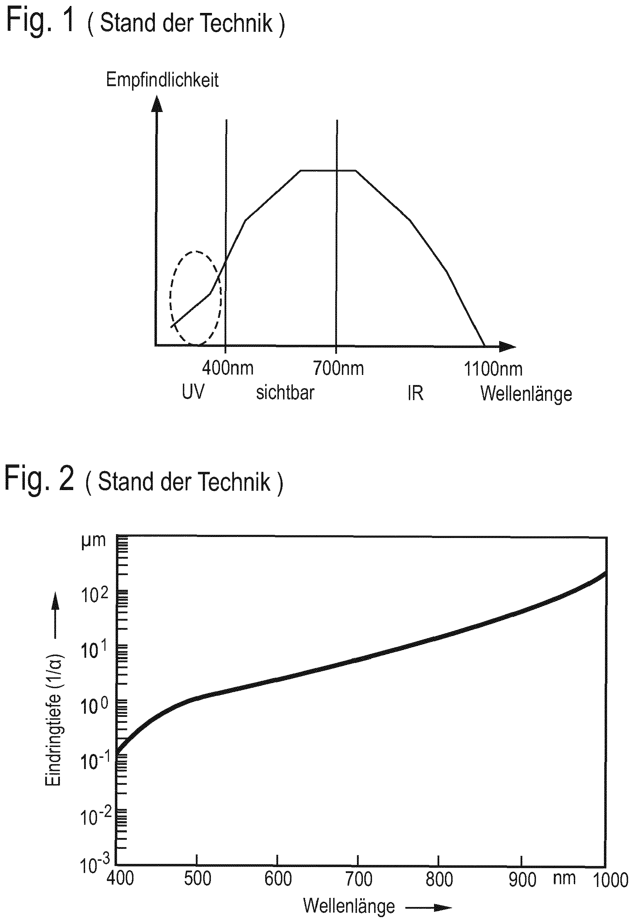

Bekannt sind UV-empfindliche Fotodioden auf Siliziumbasis. Nachteilig für den Einsatz von Si-Dioden im UV-Wellenlängenbereich ist allerdings, dass das Empfindlichkeits- bzw. Sensitivitätsmaximum im Wellenlängenbereich von (600...800)nm liegt. Die Begriffe Empfindlichkeit und Sensitivität werden synonymhaft verwendet. Im UV-Bereich von (280...400)nm ist die Empfindlichkeit der Si-Dioden geringer als im VIS/IR-Wellenlängenbereich (Fig.1). Dabei beschreibt VIS den sichtbaren, d.h den visuellen Bereich des elektromagnetischen Spektrums und IR den infraroten Bereich. Um die Empfindlichkeit auch für den UV-Bereich zu bewirken, werden Filter eingesetzt, die nur für den interessierenden UV-Wellenlängenbereich transparent und für jede andere Strahlung des elektromagnetischen Spektrums undurchlässig sind.

Bei Sensoren aus Silizium besteht weiterhin der Nachteil, dass die langwelligeren Anteile der gemessenen Strahlung eine höhe Eindringtiefe in das Silizium besitzen, mit der Folge, dass die eindringenden Photonen eine Ladungsträgergeneration und/oder Ladungsträgerabsaugung an den zumeist tief im Bulkmaterial und von der Eintrittsstelle der zu detektierenden Strahlung weit entfernt liegenden pn-Übergängen bewirken und damit die Messwerte verfälschen. Fig. 2 zeigt die Eindringtiefe in Silizium in Abhängigkeit von der Wellenlänge der auftreffenden Strahlung (http://www.elektroniknet.de/automation/sonstiges/artikel/31 275/1/).

Weiterhin sind aus dem Stand der Technik spektral optimierte UV-Fotodioden bekannt. Spektral optimiert bedeutet, dass das spektrale Empfindlichkeitsmaximum der Detektoren im UV-Bereich von (280...400)nm liegt, d.h. die Detektoren sind für Messungen des UV-Anteils in einem elektromagnetischen Strahlungsspektrum optimiert. Dies kann einerseits durch die Materialauswahl für die eingesetzte Fotodiode und damit durch die vorbestimmte spektrale Empfindlichkeitscharakteristik beeinflusst werden, zum anderen kann ein zusätzlicher Filter zum Einsatz kommen, der nur für den interessierenden UV-Wellenlängenbereich transparent ist. Beispielsweise sind Fotodioden auf der Basis von Silizium-Karbid, Indium Gallium Nitrid, Gallium Nitrid oder Aluminium Gallium Nitrid bekannt.

Des Weiteren sind sowohl bei spektral optimierten UV-Fotodioden hohe Anforderungen an die Auswerteeinheit zustellen. Beispielsweise ist für eine verwertbare Messung immer zumindest ein Referenzsensor notwendig. Auch ist keine einfache Kombination mit anderen optischen Sensoren, beispielsweise Umgebungslichtsensoren (ALS), Farb- bzw. Farbtemperatursensoren (RGB Sensor) oder Annäherungssensor (Proximity sensor - PS) möglich.

Oft werden die UV-empfindlichen Fotodioden auch in Auswerte- und Steuereinheiten umfassende Schaltungen, in sogenannten ICs integriert. Der Nachteil bekannter IC Bauformen besteht darin, dass diese neben einer geringen UV-Empfindlichkeit auch eine hohe spektrale Empfindlichkeit im sichtbaren und Infrarot-Bereich besitzen (Fig.1) (vgl. auch DE 10 2012 001 481 A1 und DE 10 2012 001 070 A1). Somit kann der UV-Anteil in einem gemessenen Lichtspektrum nur über Korrelationsrechnungen ermittelt werden, wobei dafür das Lichtspektrum bekannt sein muss. In der Praxis ist dies allerdings oft nicht der Fall. So würde ein optischer Sensor, welcher beispielsweise auf das Spektrum des Sonnenlichts normiert wäre, fehlerhafte Messwerte bei Betrieb unter Kunstlicht liefern, aufgrund der unterschiedlichen Wellenlängenanteile im Spektrum des Kunst- und Sonnenlichtes. Auch spielt die zeitliche Änderung des Spektrums des Sonnenlichtes im Laufe eines Tages eine Rolle. Wird die zeitliche Änderung nicht berücksichtigt, liefert die Messung des UV-Licht-Anteiles nur ungenaue Werte. Daher sind exakte Messungen des UV-Licht-Anteils einer Strahlungsquelle nur möglich, wenn der Sensor ausschließlich im zu messenden UV-Bereich empfindlich bzw. sensitiv ist. Unter einer Strahlungsquelle kann jeder Körper mit einer Temperatur über dem absoluten Nullpunkt verstanden werden, der elektromagnetische Strahlung aussendet. Jeder Körper mit einer Temperatur über dem absoluten Nullpunkt sendet ein charakteristisches elektromagnetisches Spektrum in Abhängigkeit von seiner Temperatur aus.

Der interessierende UV-Wellenlängenbereich liegt bei (280...400) nm. Der Bereich von (280...320) nm wird als UV-B und der Bereich von (320...400)nm als UV-A bezeichnet, wobei der UV-A-Anteil, den für die menschliche Haut gefährlicheren Anteil darstellt. Der IR-Wellenlängenbereich umfasst den Wellenlängenbereich von (0, 78...1000)$\mu$m. Der VIS-Wellenlängenbereich umfasst das sichtbare Spektrum im Wellenlängenbereich von (400...780)nm.

Es ist Aufgabe der Erfindung, in einem CMOS-Prozess hergestellte UV-Licht-Sensoren bereitzustellen, die die im Stand der Technik genannten Nachteile ausräumen, wobei der UV-Sensor ausschließlich im UV-Wellenlängenbereich sensitiv sein soll bzw. mit entsprechenden Maßnahmen jegliche Störstrahlung außerhalb des UV-Bereiches derart unterdrückt wird, dass der Sensor keine Sensitivität in anderen Wellenlängenbereichen aufweist bzw. das Messergebnis nicht durch Störstrahlung verfälscht wird, um damit einen genauen UV-Index-Wert zu ermitteln.

Die Aufgabe wird durch einen UV-Licht-Sensor nach dem Oberbegriffe des Anspruchs 1 dadurch gelöst, dass die Passivierungsschicht planar ausgebildet ist und das Filter direkt auf der planaren Passivierungsschicht ausgebildet ist und Streulicht unterdrückende Mittel um das mindestens eine Sensorelement und/oder um den UV-Licht-Sensor ausgebildet sind.

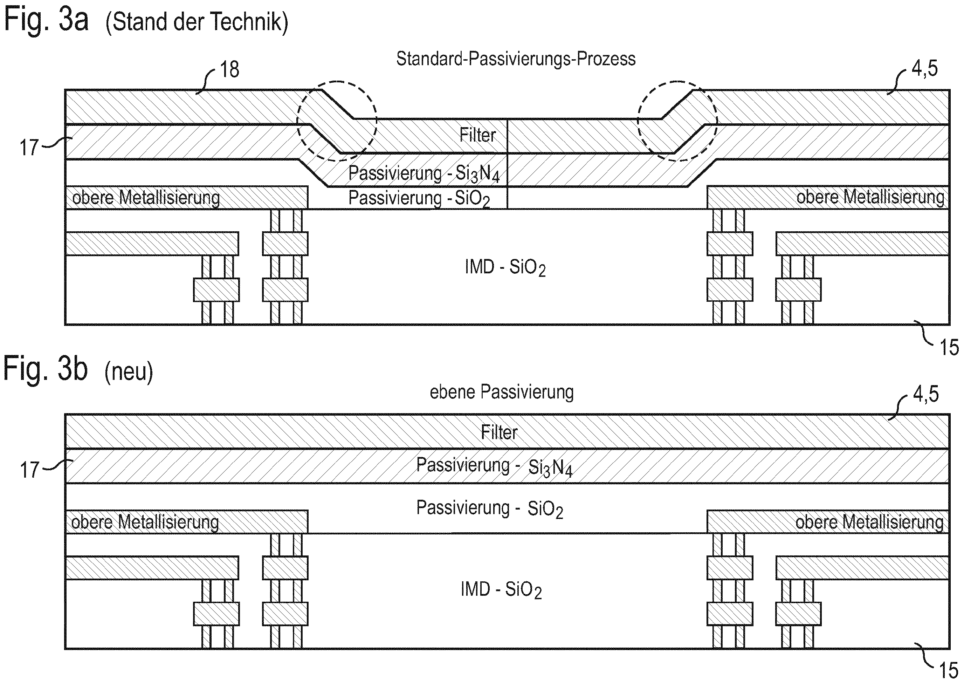

Im bisherigen CMOS-Technologieprozess wird zum Schutz vor mechanischer Beschädigung und als Diffusionsbarriere für Feuchtigkeit und Ionen nach der Herstellung der letzten Verdrahtungsebene eine Passivierungsschicht aus $SiO_2$ sowie $Si_3N_4$ aufgebracht. Dabei entstehen, wie in Fig. 3a dargestellt ist, Stufen an den Übergängen zwischen dem empfindlichen Sensorelement und der Kontaktierungsfläche, so dass keine planare Oberfläche realisiert wird. In dem erfindungsgemäßen UV-Licht-Sensor wird vor der Abscheidung des Filtermaterials die $SiO_2$-Passivierung durch einen Abtragungsprozess, beispielsweise CMP und/oder Läppen eingeebnet, so dass eine planare Abscheidung der $Si_3N_4$-Passivierung und des Filtermaterials über der gesamten Chipfläche erfolgen kann (Fig. 3b). Damit kann die Lebensdauer unter harschen Umwelteinflüssen des Filters verbessert werden. Durch die zuvor erfolgte Planarisierung der Passivierungsschicht kann das Filtermaterial auf einer planaren Oberfläche abgeschieden werden, wodurch gleichmäßigere optische Eigenschaften aufgrund der homogenen Schichtdicken des oder der Filter über der gesamten Chipfläche erzielt werden.

Durch die vorgeschlagenen Streulicht unterdrückenden Mittel kann sowohl das vertikale als auch das laterale/horizontale Eindringen von Licht auf das oder die Sensorelemente des UV-Licht-Sensors verhindert werden.

Die Streulicht unterdrückenden Mittel werden in einer Ausgestaltung der Erfindung zumindest teilweise durch das Filter gebildet. Dabei überdeckt das Filter mindestens das jeweilige Sensorelement vollständig, wobei das Filter sich bevorzugt noch über das jeweilige Sensorelement hinaus erstreckt. Besonders vorteilhaft ist es, wenn das Filter vollflächig auf dem gesamten UV-Licht-Sensor ausgebildet ist, und noch vorteilhafter, wenn das Filter über den gesamten IC, d.h. sich bis zu dessen Rand erstreckt. Der Rand des ICs in welchem der UV-Licht-Sensor integriert ist, wird durch die Größe des Si-Substrates bestimmt. Die Funktionsschicht, welche als mindestens ein Filter gebildet ist, kann auch aus verschiedenen Filtermaterialien gebildet sein, wobei sich die Filterkanten derart überlappen, dass das Eindringen von Streulicht verhindert wird. Bei der Verwendung verschiedener Filtermaterialien, die beispielsweise über einer Matrix aus Sensorelementen angeordnet sind, ist es besonders vorteilhaft, wenn der Übergang der verschiedenen Filtermaterialien im Bereich einer aktiven Sensorfläche, die kein UV-Licht-Sensorelement ist, ausgebildet ist. Dadurch wird zwar die optische Öffnung des darunterliegenden Sensorelementes verringert, jedoch kann dadurch eine deutliche Verringerung der Streulichteinkopplung auf angrenzende UV-Licht-Sensorelemente der Matrix aus Sensorelementen erreicht werden. Die Pads zur Kontaktierung des UV-Licht-Sensors mit der Nachfolgeelektronik oder den Auswerteschaltungen werden nicht von der Funktionsschicht überdeckt.

In einer weiteren Ausgestaltung des vorgeschlagenen UV-Licht-Sensors sind die Streulicht unterdrückenden Mittel zumindest teilweise durch eine ganzflächige auf dem UV-Licht-Sensor und/oder dem gesamten IC angeordnete, die Sensorelemente frei lassende Metallschicht gebildet. Damit wird ein Vordringen von Licht bis zur Siliziumoberfläche an den Stellen, die nicht von Filtern bedeckt werden können (z.B. Flächen um die Bond-Pads herum), verhindert. Des Weiteren kann Restlicht, welches aufgrund einer begrenzten Stopp-Band-Unterdrückung des Filters in den IC eindringen würde, vom Auftreffen auf die Siliziumoberfläche abgeschirmt werden.

In einer Ausgestaltung des vorgeschlagenen UV-Licht-Sensors sind die Streulicht unterdrückenden Mittel zumindest teilweise durch den UV-Licht-Sensor lateral begrenzende Lichtbarrieren gebildet. Lateral begrenzende Lichtbarrieren sind Grenzen aus geeigneten lichtabschirmenden Materialien, die ein laterales bzw. seitliches Eindringen von Licht in den UV-Licht-Sensor und damit in den IC, in welchem der UV-Licht-Sensor integriert ist, verhindern.

In einer weiteren Ausgestaltung des vorgeschlagenen UV-Licht-Sensors sind die Streulicht unterdrückenden Mittel zumindest teilweise durch eine Einbettung des UV-Licht-Sensors in ein lichtundurchlässiges Material gebildet, wobei das lichtundurchlässige Material den Rand des UV-Licht-Sensors umschließt. Das lichtundurchlässige Material kann ein Mold-Material sein, welches sich stoffschlüssig in einem Verpackungsprozess um den IC herum anschmiegt.

Weiterhin werden in einer Ausgestaltung des vorgeschlagenen UV-Licht-Sensors die Streulicht unterdrückenden Mittel zumindest teilweise durch ein lichtundurchlässiges Material auf der Rückseite des UV-Licht-Sensors gebildet. Durch eine Abkapselung des ICs mit Mold-Material im Verpackungsprozess kann die Streulichteinstrahlung über die Rückseite des ICs verhindert werden.

In einer weiteren Ausgestaltung des vorgeschlagenen UV-Licht-Sensors werden die Streulicht unterdrückenden Mittel zumindest teilweise durch mit lichtundurchlässigem Material gefüllte Gräben, das jeweilige Sensorelement lateral begrenzend, gebildet. Die Gräben können durch Ätzungen in die Passivierungsschicht hinein gebildet werden, so dass sogenannte Passivierungsätzgräben entstehen. Dadurch kann eine Unterdrückung von Lichtleitung in der Passivierungsebene bewirkt werden.

Auch können in einer weiteren Ausgestaltung des vorgeschlagenen UV-Licht-Sensors Reflexionen und Lichtleitung in intermetallischen Dielektrika im Metallisierungskomplex des IC, d.h. den Oxiden zwischen den Verdrahtungsebenen verhindert werden, indem die Streulicht unterdrückenden Mittel zumindest teilweise durch zur Substratoberfläche vertikale Lichtbarrieren in den CMOS-Verdrahtungsebenen oberhalb der im Substrat ausgebildeten Sensorelemente gebildet werden. In einer besonderen Ausgestaltung werden die vertikalen Lichtbarrieren in den CMOS-Verdrahtungsebenen durch geschlossene Kontaktringe oder/und versetzt angeordnete Via-Ringe bis in eine Top-Metall-Ebene des CMOS-Prozesses gebildet, wobei diese nur durch die minimal notwendige elektrische Kontaktierung der Fotodioden, d.h. der Sensorelemente, unterbrochen werden. Bei einer mehrstufigen Ringstruktur sind die Durchdringungsöffnungen (Vias) für die Anschlussleitungen der Sensorelemente versetzt angeordnet, so dass kein durchgehender Lichtpfad entsteht. Ein Lichtpfad beschreibt den Weg von der Eindringstelle der Strahlung in das Substrat bis hin zum empfindlichen Sensorelement.

In einer besonderen Ausgestaltung des UV-Licht-Sensors sind mehrere Sensorelemente in einer Matrix angeordnet, wobei die Sensorelemente mindestens eine Fotodiode mit UV-Filter, eine Fotodiode als ausgebildeten ALS-Sensor und eine Fotodiode mit einer Poly-Silizium-Abdeckung und einem UV-Filter umfassen.

Vorzugsweise kann die Matrix als 4x4 Matrix mit optimierter Halbraumempfindlichkeit ausgebildet sein, wobei die Matrix aus vier verschiedenen Sensorelementen gebildet wird. Die Sensorelemente können als eine Fotodiode mit UV-Filter und/oder einen ALS-Sensor und/oder eine Fotodiode mit einer Poly-Silizium-Abdeckung und einem UV-Filter ausgebildet sein. Der Halbraum des UV-Licht-Sensors schließt den kompletten Raum oberhalb des UV-Licht-Sensors ein, d.h. oberhalb der Substratebene, wobei bei einer optimierten Halbraumempfindlichkeit die Empfindlichkeit des UV-Licht-Sensors aus jeder Raumrichtung des Halbraumes möglichst gleich sein soll.

Die optimierte Halbraumempfindlichkeit ist dadurch eingestellt, dass die verschiedenen Sensorelemente folgende Anordnungskriterien erfüllen:

- jedes Sensorelement ist einmal in der Ecke der Matrix angeordnet,
- jedes Sensorelement ist zweimal an der Seitenkante der Matrix angeordnet,
- jedes Sensorelement ist einmal pro Zeile der Matrix angeordnet,
- jedes Sensorelement ist einmal pro Spalte der Matrix angeordnet,
- jedes Sensorelement ist einmal in den 4 2x2-Unterquadraten der Matrix angeordnet. Der Vorteil dieser Anordnung ist, dass damit gezielt das in das Array eintretende Streulicht auf alle Sensorelement gleich verteilt werden kann, d.h. jedes Sensorelement sieht möglichst gleiche Streulichtanteile, wobei dies auch bei verschiedenen Einfallswinkeln des Lichtes möglich ist. Damit können beispielsweise auch Einflüsse auf das Messsignal durch Partikel oder Fertigungsrückstände auf dem UV-Licht-Sensor unterdrückt werden. Denn gerade durch die Anordnung und die mögliche Mittelung von Lichtanteilen aus allen Raumrichtungen oberhalb des UV-Licht-Sensors kann die Halbraumempfindlichkeit wesentlich optimiert werden.

Weiterhin können für die verschiedenen Sensorelemente auch interferenzbasierte Filter mit hoch-brechenden Materialien verwendet werden, um eine geringe spektrale Winkelabhängigkeit zu erhalten.

Die Aufgabe der Erfindung wird verfahrensseitig durch ein Verfahren zur Detektion von UV-Licht mit dem vorgeschlagenen UV-Licht-Sensor, wobei das eine oder die mehreren Sensorelemente Licht detektieren und im Ansprechen darauf ein Signal liefern, dadurch gelöst, dass ein erstes Ausgangssignal eines Sensorelementes, welches als Fotodiode ausgebildet ist, gemessen wird, dass ein zweites Ausgangssignal eines Sensorelementes, welches als Fotodiode mit einer Poly-Silizium-Abdeckung ausgebildet ist, gemessen und mit einem Faktor gewichtet wird eine mathematische Verknüpfung zwischen dem ersten und zweiten Ausgangssignal ermittelt wird. Als mathematische Verknüpfung kann beispielsweise die Differenz zwischen dem ersten und dem zweiten Ausgangssignal berechnet werden.

Dabei wird das erste Ausgangssignal durch einen UV-Anteil, einen VIS/IR-Anteil und einen Leckstrom-Anteil gebildet und das zweite Ausgangssignal durch einen gewichteten VIS/IR-Anteil und einen gewichteten Leckstrom-Anteil gebildet. Durch die Anwendung des Differenzprinzips kann die VIS/IR-Empfindlichkeit des UV-Licht-Sensors kompensiert werden, indem der durch die Fotodiode mit der Poly-Silizium-Abdeckung lediglich der VIS/IR-Anteil und der Leckstrom-Anteil gemessen werden und das Messsignal der Fotodiode um diese Anteile korrigiert wird.

In einem weiteren erfindungsgemäßen Verfahren zur Detektion von UV-Licht mit dem erfindungsgemäßen UV-Licht-Sensor wird die Aufgabe der Erfindung dadurch gelöst, dass ein erstes Ausgangssignal eines Sensorelementes, welches als Fotodiode ausgebildet ist, gemessen wird, ein zweites Ausgangssignal eines Sensorelementes, welches als Dunkeldiode ausgebildet ist gemessen und mit einem Faktor gewichtet wird, wobei die Dunkeldiode durch ein lichtundurchlässiges Metall abgedeckt ist und eine mathematische Verknüpfung zwischen dem ersten und zweiten Ausgangssignal ermittelt wird. Als mathematische Verknüpfung kann beispielsweise die Differenz zwischen dem ersten und den zweiten Ausgangssignal berechnet werden. Durch die Anwendung des Differenzprinzips können die temperaturabhängigen Dunkelströme (Leckströme) des UV-Licht-Sensors kompensiert werden, indem durch die Dunkeldiode aufgrund der lichtundurchlässigen Metallabdeckung lediglich der Leckstrom gemessen wird und damit das Messsignal der Fotodiode um diese Anteile korrigiert werden kann.

Die beiden vorbenannten Kompensationsverfahren können auch kombiniert werden, wobei dadurch sowohl die VIS/IR-Empfindlichkeit als auch die Dunkelströme (Leckströme) kompensiert werden können und damit ein genauer UV-Index-Wert ermittelt wird.

Mit dem oben beschriebenen UV-Licht-Sensor und den beschriebenen Auswerteverfahren kann eine monolithische Integration eines Einzel- oder Mehrkanal UV-Licht-Sensors mit Auswerteeinheiten in einem CMOS Prozess sehr einfach erfolgen. Die spektrale Anpassung der Sensorempfindlichkeiten im UV-Wellenlängenbereich kann durch ein einfaches Aufbringen von dedizierten optischen Filtern angepasst werden. Durch die Integration in einen CMOS Prozess ist eine Verknüpfung der UV-Licht-Sensorfunktion mit weiteren Umweltsensoren, wie ALS, RGB, PS, Druck, Gas, Feuchtigkeit möglich, wobei dies keine abschließende Aufzählung darstellt. Durch die erfindungsgemäße Anordnung kann das Eindringen von Streulicht, welches um den aufgebrachten optischen Filter herum in den UV-Licht-Sensor bzw. den IC eindringt, verhindert werden.

Die Erfindung soll nachfolgend anhand von Ausführungsbeispielen näher erläutert werden.

In den zugehörigen Zeichnungen zeigen

Fig. 1     Spektrale Empfindlichkeit von bekannten IC-Aufbauten;

Fig. 2     Eindringtiefe von Strahlung in Silizium in Abhängigkeit von der Wellenlänge der auftreffenden Strahlung;

Fig. 3     Passivierungsprozess a) nach dem Stand der Technik, b) gemäß der vorliegenden Erfindung;

Fig. 4     Draufsicht auf einen IC mit UV-Licht-Sensor, wobei der komplette IC mit UV-Filter (schraffiert), ausgenommen Pads und eventuelle andere Filter-Positionen (eng-schraffiert) abgedeckt ist;

Fig. 5     Überlappung der Filter, um möglichst wenig Streulicht an den Grenzstellen eindringen zu lassen; Der UV Filter wird dabei möglichst weit bis an die optische Öffnung des anderen Sensorelementes heran geführt, um den Bedeckungsgrad des UV Filters zu maximieren; a) Draufsicht, b1) das zweite Filtermaterial überdeckt das UV-Filter, b2) das UV-Filter überdeckt das zweite Filtermaterial;

Fig. 6     Ausdehnung des UV-Filter (schraffiert) bis in die optische Öffnung des ALS Sensors hinein, a) Draufsicht, b) Seitenansicht;

Fig. 7     Draufsicht auf einen IC mit UV-Licht-Sensor-Abdeckung des kompletten ICs mit Metall, ausgenommen sind die Sensorelemente;

Fig. 8     Schematische Darstellung eines IC mit UV-Licht-Sensor in einem Gehäuse a) ohne und b) mit Streulicht verhindernden Mitteln, u.a. mit den IC lateral begrenzenden Lichtbarrieren;

Fig. 9     Schematische Darstellung eines IC mit UV-Licht-Sensor in einem Gehäuse mit Lichtbarrieren, Einbettung in lichtundurchlässigen Mold-Material, Anordnung von lichtundurchlässigen Mold-Material auf der IC Rückseite;

Fig. 10    Schematische Darstellung von Streulicht unterdrückenden Mittel, die aus geschlossenen Kontaktringen und/oder versetzt angeordneten Via-Ringen gebildet sind, wodurch das Eindringen von Streulicht über Lichtleitung oder Reflexionen verhindert wird;

Fig. 11    Schematische Darstellung der Kompensation mit einer Fotodiode, welche mit Poly-Si abgedeckt ist, für den Fall a) ohne UV-Filter und b) mit UV-Filter;

Fig. 12    Schematische Darstellung einer Matrix aus Dioden mit verschiedenen Filtern und damit mit verschiedenen Funktionen;

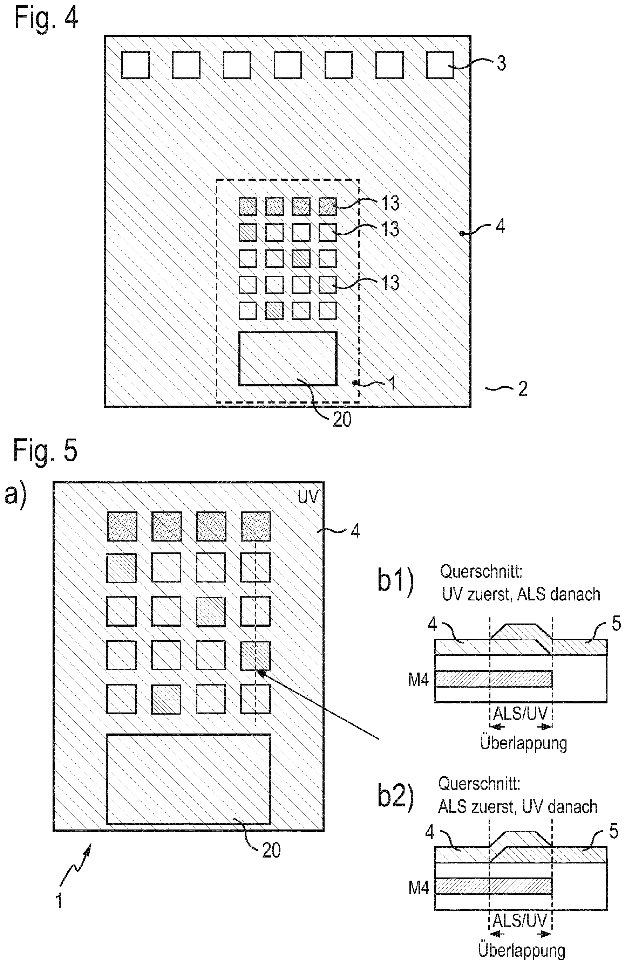

Fig. 4 zeigt eine Ausgestaltung der Erfindung, bei der das Filter 4 großflächig auf dem IC 2 mit dem integrierten UV-Licht-Sensor 1 mit zugehöriger Signalverarbeitung 20 ausgebildet ist. Dadurch kann ein vertikales Eindringen von Licht außerhalb eines oder mehrerer Sensorelemente 13 verhindert werden. Dabei werden die Pads zur Kontaktierung 3 für den IC nicht von dem Filter 4 bedeckt. Es ist auch möglich über einzelnen Sensorelementen 13 verschiedene Filter 4, 5 anzuordnen, wobei mit den Sensorelementen 13 dann verschiedene Strahlungsanteile detektiert werden können. In einer Ausgestaltung können einige Sensorelemente als Dunkeldioden DD ausgebildet sein, auf die gar keine Strahlung trifft.

Werden verschiedene Filter 4, 5 innerhalb eines UV-Licht-Sensors 1 eingesetzt, so darf auch an den Übergangsbereichen der Filter 4, 5 keine Störstrahlung auf die Sensorelemente 13 gelangen. Um dies zu verhindern, werden die verschiedenen Filtermaterialien in den Übergangsbereichen überlappt ausgebildet, wie dies ist in Fig. 5 b1), b2) schematisch dargestellt ist.

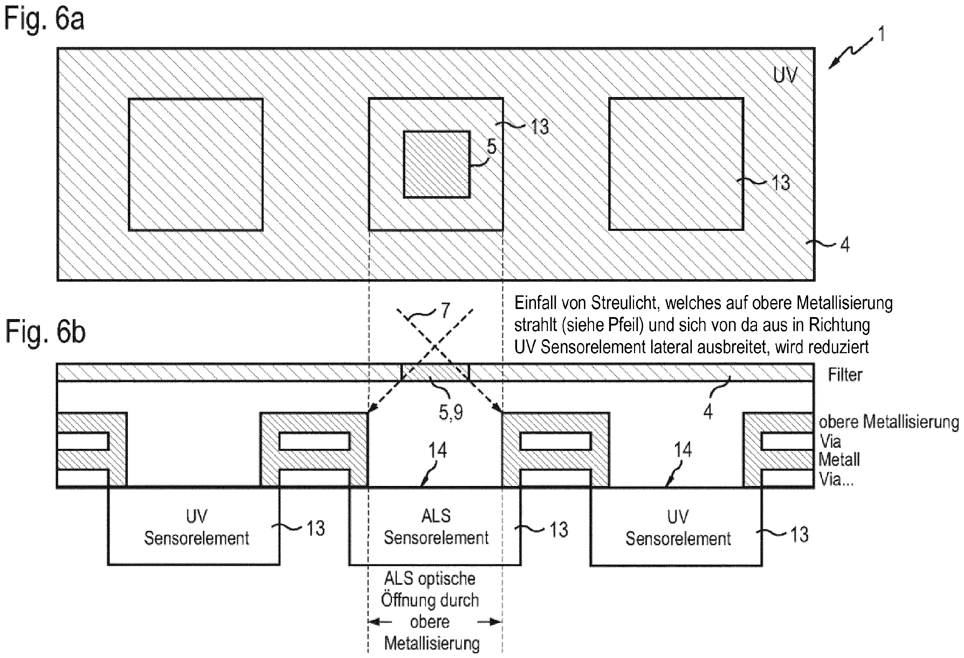

Fig. 6 zeigt eine Ausgestaltung der Erfindung, bei der die Streulicht unterdrückenden Mittel aus zwei verschiedenen Filtermaterialien 4, 5 gebildet werden. Zum einen aus einem UV-Filter 4 und zum anderen aus einem zweiten Filtermaterial 5. Die Filter sind über einer Matrix aus Sensorelementen 13 angeordnet, wobei die Sensorelemente 13 UV-und ALS-Sensorelemente umfassen. Die zwei Filtermaterialien 4, 5 sind derart angeordnet, dass der UV-Filter 4 über den UV-Sensorelementen und das zweite Filtermaterial 5 über den ALS-Sensorelementen positioniert sind. Dabei ist besonders vorteilhaft, wenn die Ausdehnung des UV-Filters 4 bis in die optische Öffnung 9 des ALS-Sensorelementes hinein reicht (Fig. 6b). Dabei wird die Apertur bzw. Blende oder optische Öffnung des ALS Sensorelementes durch den UV-Filter 4 verringert und damit dessen Empfindlichkeit reduziert, bspw. 1/3 Fläche entspricht einer Abnahme der Empfindlichkeit des ALS-Sensorelementes 13 um 1/3. Die verringerte Empfindlichkeit kann jedoch toleriert werden, da sich durch die Überdeckung eine deutliche Verringerung der Streulichteinkopplung auf die angrenzenden UV-Sensorelemente 13 erreichen lässt. Denn durch die Ausweitung des UV-Filters 4 in die aktive Sensorfläche 14 des ALS-Sensorelementes hinein (d.h. in Projektion über die aktive Sensorfläche 14), gelangt deutlich weniger Streulicht durch den ALS-Filter 5 auf das Top Metall. Im Top Level würde sich das eingekoppelte Streulicht 7 nämlich wiederum wie in einem Lichtleichter zu dem UV-Sensorelementen 13 fortbewegen können. Dies kann durch die beschriebene Ausgestaltung deutlich reduziert werden.

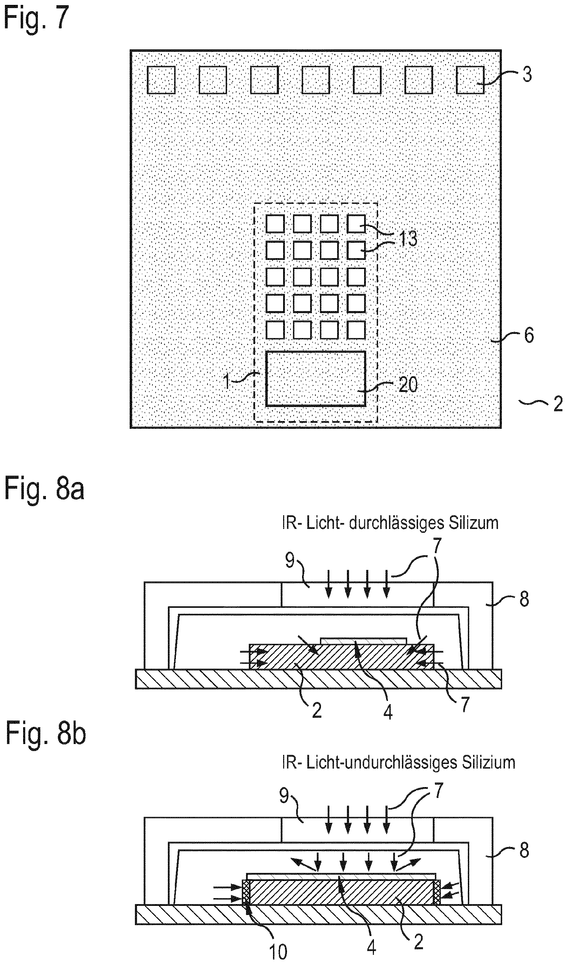

Fig. 7 zeigt eine großflächige Metallabdeckung 6 des gesamten ICs 2 mit dem integrierten UV-Licht-Sensor 1. Damit kann ein Vordringen von Licht bis zur Siliziumoberfläche an den Stellen, die nicht von Filtern bedeckt werden können (z.B. Flächen um die Bond-Pads 31 (nicht dargestellt) der einzelnen Sensorelemente herum), verhindert werden. Des Weiteren kann damit Restlicht, welches aufgrund einer begrenzten Stopp-Band-Unterdrückung des Filters in den IC 2 eindringen würde, vom Auftreffen auf die Siliziumoberfläche abgeschirmt werden.

Fig. 8 zeigt eine schematische Darstellung eines IC 2 mit UV-Licht-Sensor 1 in einem Gehäuse 8. Dabei zeigt Fig.8a die eindringende Störstrahlung in den UV-Licht-Sensor 1, aufgrund der fehlenden Streulicht unterdrückenden Mittel, wohingegen in Fig. 8b den IC 2 lateral begrenzende Lichtbarrieren 10 angeordnet sind, um das Eindringen der Störstrahlung in den UV-Licht-Sensor 1 außerhalb der empfindlichen Sensorfläche 1 zu verhindern.

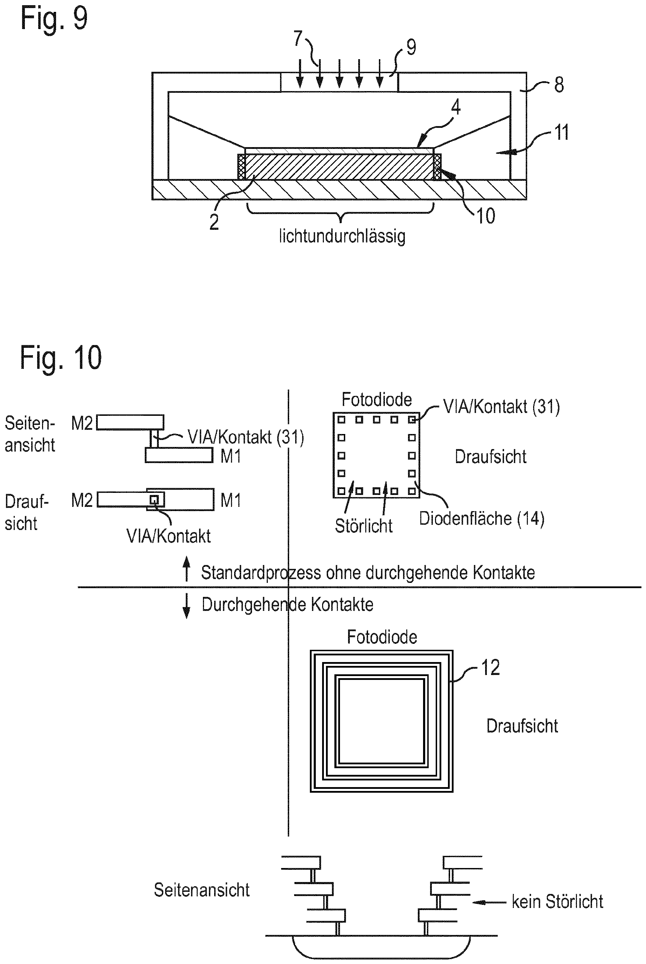

Fig. 9 zeigt eine Art Zusammenfassung der möglichen Streulicht unterdrückenden Mittel. Das vertikale Eindringen von Licht 7 von der Rückseite des IC 2 oder UV-Licht-Sensors 1 kann durch eine Abkapselung mit einem lichtundurchlässigen Material 11, Z.B. einem geeigneten Mold-Material im Verpackungsprozess verhindert werden. Des Weiteren kann das horizontale Eindringen von Licht 7 über die IC-Chipkanten durch die Bedeckung des Chiprandes mit geeignetem lichtabschirmendem Materialien 11 beim Verpackungsprozess erreicht werden, wobei beispielsweise den IC 2 lateral begrenzende Lichtbarrieren 10 angeordnet werden, oder der gesamte IC 2 in einem lichtundurchlässigen Mold-Material 11 eingebettet wird.

Fig. 10 zeigt eine schematische Darstellung von Streulicht unterdrückenden Mittel, die aus geschlossenen Kontaktringen 12 und/oder versetzt angeordneten Via-Ringen gebildet sind, wodurch das Eindringen von Streulicht durch Reflexionen oder über Lichtleitung in den intermetallischen Dielektrika im Metallisierungskomplex des IC 2 (Oxide zwischen Verdrahtungsebenen) bzw. Passivierungsebenen verhindert wird.

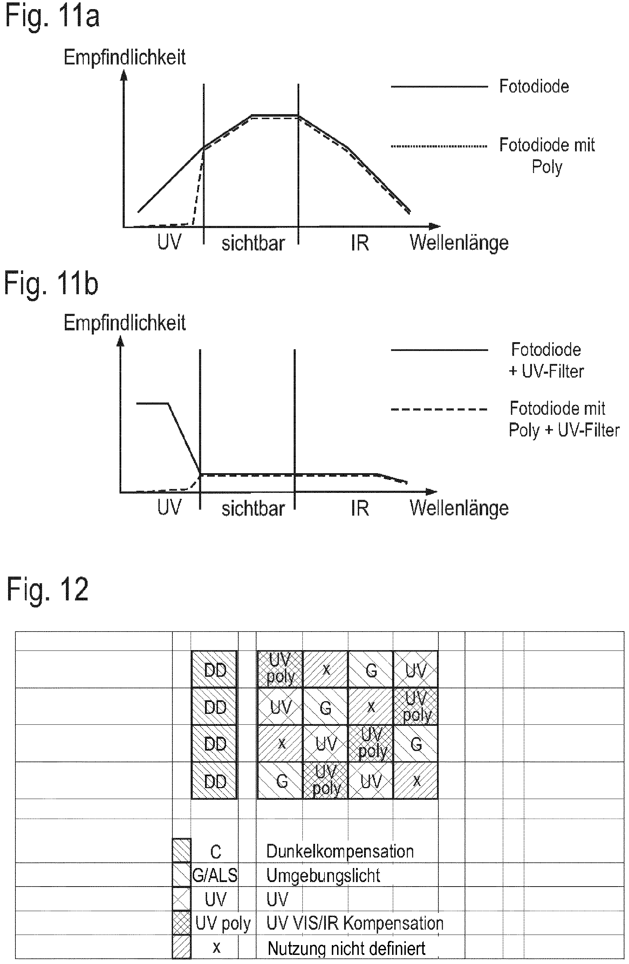

Fig. 11 zeigt eine schematische Darstellung des Ergebnisses der Kompensation der VIS/IR-Empfindlichkeit einer Si-Fotodiode durch die Kompensation mit einer Fotodiode, welche mit Poly-Si abgedeckt ist, für den Fall a) ohne UV-Filter und b) mit UV-Filter, wofür das erfindungsgemäße Verfahren zur Detektion von UV-Licht mit einem UV-Licht-Sensor 1 verwendet wurde. Beispielsweise kann in einem UV-Licht-Sensor 1, bestehend aus mindestens einer Fotodiode mit UV-Filter (UV-Diode) und mindestens einer mit einer Polysilizium Schicht abgedeckten Fotodiode mit UV-Filter (UV-Poly-Diode), die VIS/IR-Empfindlichkeit der Si-Dioden durch folgende beispielhafte Verfahrensschritte unterdrückt werden: Das Ausgangssignal der UV-Diode wird gemessen. Dieses setzt sich aus den Anteilen UV + VIS/IR-Streulicht + Leckstrom zusammen. Mit der Poly-UV-Diode wird ein zweites Ausgangssignal gemessen. Dieses setzt sich aus den Anteilen a1*VIS/IR-Streulicht + a2*Leckstrom zusammen. Das Streulicht beider Dioden ist nicht identisch, dargestellt durch den Faktor a1, welcher ungleich 1 ist. Somit wäre die Differenz nicht genau der gewünschte UV-Anteil, also die Kompensation nicht optimal. Die Optimierung wird erreicht, indem eine gewichtete Differenz gebildet wird, bspw. die UV-Poly-Diode zunächst mit 1/(a1) gewichtet und dann die Differenz gebildet wird. Die Leckströme werden kompensiert für den Fall das a2 (nahezu) 1 ist.

Für die Unterdrückung der VIS/IR-Empfindlichkeit der Si-Dioden können auch vertikal gestapelten PN-Übergängen (gepinchte Si-Dioden) verwendet werden, um die VIS/IR-Empfindlichkeit aus dem genutzten Fotostrom zu eliminieren.

Im Prinzip erfolgt dabei eine Trennung der aus Ladungsträgergeneration resultierenden Fotoströme in Anteile die durch langwelliges Licht in größerer Tiefe des Siliziums erzeugt werden und jene die durch kurzwelliges Licht an der Oberfläche erzeugt werden.

In einem weiteren Ausführungsbeispiel wird zur Unterdrückung von temperaturabhängigen und fertigungsbedingten Leckströmen ebenfalls ein Kompensationsverfahren angewendet, wobei in einem UV-Licht-Sensor (1), bestehend aus mindestens einer Fotodiode mit UV-Filter (UV-Diode) und mindestens einer mit einer Metallschicht abgedeckten Dunkeldiode (DD), die temperaturabhängigen und fertigungsbedingten Leckströme der Si-Dioden durch folgende beispielhafte Verfahrensschritte unterdrückt werden: Das Ausgangssignal der UV-Diode wird gemessen. Dieses setzt sich aus den Anteilen UV + Leckstrom zusammen. Mit der Dunkeldiode wird ein zweites Ausgangssignal gemessen. Dieses umfasst den Anteil a2*Leckstrom. Anschließend erfolgt beispielsweise eine Kompensation durch Differenzbildung der beiden gemessenen Ausgangssignale. Im Fall, dass a2 ungleich 1 ist, wird die Optimierung dadurch erreicht, das eine gewichtete Differenz gebildet wird, bspw. die Dunkeldiode zunächst mit 1/(a2) gewichtet und dann die Differenz gebildet wird. Beispielsweise kann auch eine Speicherung von Trimmwerten zur Realisierung einer Chip- und Dioden-bezogenen programmierbaren Dunkelstrom-Kalibrierung erfolgen.

Besteht der UV-Licht-Sensor 1 aus mindestens einer Fotodiode mit UV-Filter (UV-Diode), mindestens einer mit einer Polysilizium Schicht abgedeckten Fotodiode mit UV-Filter (UV-Poly-Diode)und mindestens einer mit einer Metallschicht abgedeckten Dunkeldiode DD so kann gleichzeitig eine Kompensation der VIS/IR Empfindlichkeit und der Leckströme der Si-Fotodioden erfolgen. Wenn beispielsweise der UV-Licht-Sensor 1 eine Fotodiode mit UV-Filter (D1), eine Fotodiode mit UV-Filter, die mit einer Polysiliziumschicht abgedeckt ist (D2) und einer mit Metall abgedeckten UV-Dunkeldiode (D3) umfasst, dann setzen sich die Ausgangssignale der drei Dioden wie folgt zusammen:

$$D1 = UV + \quad VIS/IR\text{-}Streu + \quad Leckstrom;$$

$$D2 = \quad a1 * VIS/IR\text{-}Streu + a2\_2 * Leckstrom;$$

$$D3 = \quad + a2\_3 * Leckstrom.$$

In einem ersten Schritt erfolgt eine gewichtete Kompensation der Leckströme durch Berechnung von D13=(D1-x1*D3) und D23=(D2-x2*D3) sowie Festlegung von x1 und x2 unter Beachtung von a2_2 und a2_3.

In einem zweiten Schritt erfolgt die gewichtete Kompensation der VIS/IR-Empfindlichkeit durch Berechnung von UV=D13-x3*D23 sowie Festlegung von x3 unter Beachtung a1.

Die Homogenisierung der Leckströme kann auch durch optimierte Ausheilung im Fertigungsprozess erfolgen.

Besteht der UV-Licht-Sensor 1 aus einer Matrix aus mehreren Sensorelementen (Fig. 12), kann durch eine nach bestimmten Anordnungskriterien zusammengesetzte Filteranordnung, wobei die Filter aus funktionsabhängigen Filtermaterialien bestehen, verbliebenes Streulicht - oder unterschiedliche Leckstromeffekte homogenisiert werden. Beispielsweise kann damit auch eine optimale Halbraumempfindlichkeit des UV-Licht-Sensors 1 und unter Umständen eine Unterdrückung von Partikeln oder Fertigungsrückständen auf dem UV-Licht-Sensor 1 kompensiert werden. Dabei sind die den UV-Licht-Sensor 1 bildenden Sensorelemente 13 in einer Matrix-Struktur angeordnet, wobei mittels einer geometrischen Schwerpunktbildung eine gleichbewertende Mitteilung von Lichtanteilen aus allen Raumrichtungen oberhalb des UV-Licht-Sensors erfolgt. Sind bei einer 4x4-Matrix-Anordnung mit insgesamt 16 Fotodioden, diesen 16 Fotodioden vier verschiedene Filtermaterialien zugeordnet, d.h die Fotodioden erfüllen entsprechend ihrem zugeordneten Filter verschiedene Funktionen, so muss die Filterzuordnung folgende Kriterien erfüllen: Die vier verschiedenen Filter sind einmal in der Ecke, zweimal an der Seitenkante, einmal pro Zeile, einmal pro Spalten und einmal in den vier 2x2-Unterquadraten angeordnet. Die vier verschiedenen Filter sind dann auch verschiedenen Messkanälen zugeordnet. Fig. 12 zeigt eine derartige Anordnung von verschiedenen Filtern. Dabei ist besonders vorteilhaft, dass in das Array eintreffende Streulicht, zum Beispiel wenn der mit G bezeichnete Filter anstatt mit UV-Filter mit einem anderen Filter bedeckt wird, bspw. einem fotooptischen Filter, tritt gewollt sichtbares Licht durch diesen Filter ein, welches dann zu den UV-Dioden und UV-Poly-Dioden streuen kann. Um deren Streulichtkompensation nicht negativ zu beeinflussen, sollten diese Dioden möglichst gleiche Streulichtanteile sehen, auch bei verschiedenen Einfallswinkeln des Lichtes.

**Bezugszeichenliste**

| 1 | UV-Licht-Sensor |
|---|---|
| 2 | IC (integrated circuit) |
| 3 | Kontaktierungspads |
| 31 | Vias, Bondpads der Sensorelemente |
| 4 | UV-Filter |
| 5 | zweites Filtermaterial |
| 6 | Metallschicht |
| 7 | einfallende Strahlung |
| 8 | Gehäuse |
| 9 | optische Öffnung |
| 10 | Lichtbarriere |
| 11 | lichtundurchlässiges Material |
| 12 | geschlossene Kontaktringe |
| 13 | Sensorelement |
| 14 | aktive Sensorelementfläche |
| 15 | Substrat |
| 16 | Substratoberfläche |
| 17 | Passivierungsschicht |
| 18 | Funktionsschicht |
| 19 | Streulicht unterdrückende Mittel |
| 20 | Verarbeitungseinheit des IC |
| DD | Dunkeldiode |

## Patentansprüche

1. UV-Licht-Sensor (1), hergestellt mit einem CMOS-Prozess, umfassend ein Substrat mit einer Oberfläche, einen oder mehrere eine Strahlung detektierende Sensorelemente (13), die in dem Substrat (15) ausgebildet sind, mindestens einer über der Oberfläche (16) des Substrates angeordneten Passivierungsschicht (17), sowie einer über der Passivierungsschicht (17) angeordneten Funktionsschicht (18), wobei die Funktionsschicht (18) als mindestens ein Filter (4, 5) ausgebildet ist, die Passivierungsschicht (17) planar mittels eines Abtragungsprozesses ausgebildet ist und das Filter (4, 5) direkt auf der planaren Passivierungsschicht (17) ausgebildet ist und Streulicht unterdrückende Mittel (19) um das mindestens eine Sensorelement (13) und/oder um den UV-Licht-Sensor (1) ausgebildet sind, wobei die Streulicht unterdrückenden Mittel (19) zumindest teilweise durch zur Substratoberfläche (16) vertikale Lichtbarrieren (10) in den CMOS-Verdrahtungsebenen oberhalb der im Substrat (15) ausgebildeten Sensorelemente (13) gebildet sind.

2. UV-Licht-Sensor nach Anspruch 1, **dadurch gekennzeichnet, dass** die Streulicht unterdrückenden Mittel (19) zumindest teilweise durch das Filter (4, 5) gebildet sind.

3. UV-Licht-Sensor nach Anspruch 1 oder 2, **dadurch gekennzeichnet, dass** die Streulicht unterdrückenden Mittel (19) zumindest teilweise durch eine ganzflächige auf dem UV-Licht-Sensor (1) angeordnete, die Sensorelemente (13) frei lassende Metallschicht gebildet sind.

4. UV-Licht-Sensor nach zumindest einem der vorherigen Ansprüche, **dadurch gekennzeichnet, dass** die Streulicht unterdrückenden Mittel (19) zumindest teilweise durch den UV-Licht-Sensor (1) lateral begrenzende Lichtbarrieren (10) gebildet sind.

5. UV-Licht-Sensor nach zumindest einem der vorherigen Ansprüche, **dadurch gekennzeichnet, dass** die Streulicht unterdrückenden Mittel (19) zumindest teilweise durch eine Einbettung des UV-Licht-Sensors (1) in ein lichtundurchlässiges Material (11) gebildet sind, wobei das lichtundurchlässige Material (11) den Rand des UV-Licht-Sensors (1) umschließt.

6. UV-Licht-Sensor nach zumindest einem der vorherigen Ansprüche, **dadurch gekennzeichnet, dass** die Streulicht unterdrückenden Mittel (19) zumindest teilweise durch ein lichtundurchlässiges Material (11) auf der Rückseite des UV-Licht-Sensors (1) gebildet sind.

7. UV-Licht-Sensor nach zumindest einem der vorherigen Ansprüche, **dadurch gekennzeichnet, dass** die Streulicht unterdrückenden Mittel (19) zumindest teilweise durch mit lichtundurchlässigem Material (11) gefüllte Gräben das jeweilige Sensorelement (13) lateral begrenzend gebildet sind.

8. UV-Licht-Sensor nach Anspruch 1, **dadurch gekennzeichnet, dass** die vertikalen Lichtbarrieren (10) in den CMOS-Verdrahtungsebenen durch geschlossene Kontaktringe (12) oder/und versetzt ausgebildete Via-Ringe bis in eine Top-Metall-Ebene des CMOS-Prozesses gebildet sind.

9. UV-Licht-Sensor nach einem der vorherigen Ansprüche, **dadurch gekennzeichnet, dass** die eine Strahlung detektierenden Sensorelemente (13) in einer Matrix angeordnet sind.

10. UV-Licht-Sensor nach einem der vorherigen Ansprüche, **dadurch gekennzeichnet, dass** über den eine Strahlung detektierenden Sensorelementen (13) Filter (4, 5) aus unterschiedlichen Filtermaterialien ausgebildet sind, wobei die Filter (4, 5) sich teilweise überlappend und/oder beide Filter (4, 5) teilweise die aktive Sensorelementfläche (14) überdeckend ausgebildet sind.

11. UV-Licht-Sensor nach einem der vorherigen Ansprüche, **dadurch gekennzeichnet, dass** die Sensorelemente (13) als Fotodioden oder/und ALS-Sensoren oder/und Dunkelstromkompensierende Sensoren ausgebildet sind.

12. UV-Licht-Sensor nach einem der Ansprüche 1 bis 11, **dadurch gekennzeichnet, dass** mehrere Sensorelemente (13) in einer Matrix angeordnet sind, wobei die Sensorelemente (13) mindestens eine Fotodiode mit UV-Filter, einen ALS-Sensor und eine Fotodiode mit einer Poly-Silizium-Abdeckung und einem UV-Filter (4) umfassen.

13. UV-Licht-Sensor nach 12, **dadurch gekennzeichnet, dass** die Matrix als 4x4 Matrix mit optimierter Halbraumempfindlichkeit, bestehend aus vier verschiedenen Sensorelementen (13) ausgebildet ist.

14. UV-Licht-Sensor nach Anspruch 13, **dadurch gekennzeichnet, dass** die optimierte Halbraumempfindlichkeit dadurch eingestellt ist, dass verschiedenen Sensorelemente (13) folgende Anordnungskriterien erfüllen:

   - jedes Sensorelement ist einmal in der Ecke der Dioden-Matrix angeordnet,
   - jedes Sensorelement ist zweimal an der Seitenkante der Dioden-Matrix angeordnet,
   - jedes Sensorelement ist einmal pro Zeile der Dioden-Matrix angeordnet,
   - jedes Sensorelement ist einmal pro Spalte der Dioden-Matrix angeordnet,
   - jedes Sensorelement ist einmal in den 4 2x2-Unterquadraten der Dioden-Matrix angeordnet.

15. Verfahren zur Detektion von UV-Licht mit einem UV-Licht-Sensor nach den vorherigen Ansprüche, wobei das eine oder die mehreren Sensorelemente (13) Licht detektieren und im Ansprechen darauf ein Signal liefern, **dadurch gekennzeichnet, dass**

   - ein erstes Ausgangssignal eines Sensorelementes, welches als Fotodiode ausgebildet ist, gemessen wird, dass
   - ein zweites Ausgangssignal eines Sensorelementes, welches als Fotodiode mit einer Poly-Silizium-Abdeckung ausgebildet ist, gemessen und mit einem Faktor gewichtet wird,
   - und eine mathematische Verknüpfung zwischen dem ersten und zweiten Ausgangssignal ermittelt wird.

16. Verfahren nach Anspruch 15, **dadurch gekennzeichnet, dass** als mathematische Verknüpfung die Differenz zwischen dem ersten und dem zweiten Ausgangssignal berechnet wird.

17. Verfahren nach Anspruch 16, **dadurch gekennzeichnet, dass** das erste Ausgangssignal durch einen UV-Anteil, einen VIS/IR-Anteil und einen Leckstrom-Anteil gebildet wird.

18. Verfahren nach Anspruch 16, **dadurch gekennzeichnet, dass** das zweite Ausgangssignal durch einen gewichteten VIS/IR-Anteil und einen gewichteten Leckstrom-Anteil gebildet wird.

19. Verfahren zur Detektion von UV-Licht mit einem UV-Licht-Sensor nach den Ansprüche 1 bis 13, wobei der eine oder die mehreren Sensorelement Licht detektieren und im Ansprechen darauf ein Signal liefern nach den vorherigen Ansprüche, **dadurch gekennzeichnet, dass**

   - ein erstes Ausgangssignal eines Sensorelementes, welches als Fotodiode ausgebildet ist, gemessen wird, dass

- ein zweites Ausgangssignal eines Sensorelementes, welches als Dunkeldiode ausgebildet ist, wobei die Dunkeldiode durch ein lichtundurchlässiges Metall abgedeckt ist, gemessen und mit einem Faktor gewichtet wird,

- und eine mathematische Verknüpfung zwischen dem ersten und zweiten Ausgangssignal ermittelt wird.

20. Verfahren nach Anspruch 19, **dadurch gekennzeichnet, dass** als mathematische Verknüpfung die Differenz zwischen dem ersten und dem zweiten Ausgangssignal berechnet wird.

21. Verfahren nach Anspruch 19, **gekennzeichnet durch** die Merkmale mindestens eines der Ansprüche 15 bis 18.


**Claims**

1. UV light sensor (1), produced by a CMOS process, comprising a substrate having a surface, one or a plurality of sensor elements (13) which detect a radiation and which are drawn in the substrate (15), at least one passivation layer (17) arranged above the surface of the substrate, and a functional layer (18) arranged above the passivation layer (17), wherein the functional layer (18) is formed as at least one filter (4, 5), the passivation layer (17) is formed in a planar fashion by means of a removal process and the filter (4, 5) is formed directly on the planar passivation layer (17) and stray light suppressing means are formed around the at least one sensor element (13) and/or around the UV light sensor (1), **characterized in that** the stray light suppressing means are formed at least partly by light barriers (10), which are vertical with respect to the substrate surface, in the CMOS wiring planes above the sensor elements (13) formed in the substrate (15).

2. UV light sensor according to Claim 1, **characterized in that** the stray light suppressing means are formed at least partly by the filter (4, 5).

3. UV light sensor according to Claim 1 or 2, **characterized in that** the stray light suppressing means are formed at least partly by a whole-area metal layer which is arranged on the UV light sensor (1) and leaves the sensor elements (13) free.

4. UV light sensor according to at least one of the preceding claims, **characterized in that** the stray light suppressing means are formed at least partly by light barriers (10) laterally delimiting the UV light sensor (1).

5. UV light sensor according to at least one of the preceding claims, **characterized in that** the stray light suppressing means are formed at least partly by an embedding of the UV light sensor (1) into a light-nontransmissive material (11), wherein the light-nontransmissive material (11) encloses the edge of the UV light sensor (1).

6. UV light sensor according to at least one of the preceding claims, **characterized in that** the stray light suppressing means are formed at least partly by a light-nontransmissive material (11) on the rear side of the UV light sensor (1).

7. UV light sensor according to at least one of the preceding claims, **characterized in that** the stray light suppressing means are formed at least partly by trenches filled with light-nontransmissive material (11), in a manner laterally delimiting the respective sensor element (13).

8. UV light sensor according to Claim 1, **characterized in that** the vertical light barriers (10) in the CMOS wiring planes are formed by closed contact rings (12) or/and via rings formed in an offset fashion right into a top metal plane of the CMOS process.

9. UV light sensor according to any of the preceding claims, **characterized in that** the sensor elements (13) which detect a radiation are arranged in a matrix.

10. UV light sensor according to any of the preceding claims, **characterized in that** filters (4, 5) composed of different filter materials are formed above the sensor elements (13) which detect a radiation, wherein the filters (4, 5) are formed in a partly overlapping fashion and/or both filters (4, 5) are formed in a manner partly covering the active sensor element area (14).

11. UV light sensor according to any of the preceding claims, **characterized in that** the sensor elements (13) are formed as photodiodes or/and ALS sensors or/and dark current compensating sensors.

12. UV light sensor according to any of Claims 1 to 11, **characterized in that** a plurality of sensor elements (13) are arranged in a matrix, wherein the sensor elements (13) comprise at least one photodiode with UV filter, an ALS sensor and a photodiode with a polysilicon covering and a UV filter (4).

13. UV light sensor according to Claim 12, **characterized in that** the matrix is formed as a 4×4 matrix having optimized half-space sensitivity, consisting of four different sensor elements (13).

14. UV light sensor according to Claim 13, **characterized in that** the optimized half-space sensitivity is set by different sensor elements (13) satisfying the following arrangement criteria:

- each sensor element is arranged once in the corner of the diode matrix,
- each sensor element is arranged twice at the side edge of the diode matrix,
- each sensor element is arranged once per row of the diode matrix,
- each sensor element is arranged once per column of the diode matrix,
- each sensor element is arranged once in the 4 2×2 subsquares of the diode matrix.

15. Method for detecting UV light using a UV light sensor according to the preceding claims, wherein the one or the plurality of sensor elements (13) detect light and supply a signal in response thereto, **characterized in that**

- a first output signal of a sensor element formed as a photodiode is measured,
- a second output signal of a sensor element formed as a photodiode with a polysilicon covering is measured and weighted with a factor,
- and a mathematical combination between the first and second output signals is determined.

16. Method according to Claim 15, **characterized in that** the difference between the first and second output signals is calculated as the mathematical combination.

17. Method according to Claim 16, **characterized in that** the first output signal is formed by a UV component, a VIS/IR component and a leakage current component.

18. Method according to Claim 16, **characterized in that** the second output signal is formed by a weighted VIS/IR component and a weighted leakage current component.

19. Method for detecting UV light using a UV light sensor according to Claims 1 to 13, wherein the one or the plurality of sensor elements detect light and supply a signal in response thereto, **characterized in that**

- a first output signal of a sensor element formed as a photodiode is measured,
- a second output signal of a sensor element formed as a dark diode, wherein the dark diode is covered by a light-nontransmissive metal, is measured and weighted with a factor,
- and a mathematical combination between the first and second output signals is determined.

20. Method according to Claim 19, **characterized in that** the difference between the first and second output signals is calculated as the mathematical combination.

21. Method according to Claim 19, **characterized by** the features of at least one of Claims 15 to 18.

**Revendications**

1. Capteur de lumière UV (1), fabriqué avec un processus CMOS, comprenant un substrat ayant une surface, un ou plusieurs éléments capteurs (13) qui détectent un rayonnement et qui sont réalisés dans le substrat (15), au moins une couche de passivation (17) disposée au-dessus de la surface du substrat, ainsi qu'une couche fonctionnelle (18) disposée au-dessus de la couche de passivation (17), la couche fonctionnelle (18) étant réalisée sous la forme d'au moins un filtre (4, 5), la couche de passivation (17) est réalisée plane au moyen d'un processus d'enlèvement et le filtre (4, 5) est formé directement sur la couche de passivation (17) plane et des moyens de suppression de la lumière parasite sont réalisés autour de l'au moins un élément capteur (13) et/ou autour du capteur de lumière UV (1), **caractérisé en ce que** les moyens de suppression de la lumière parasite sont formés au moins partiellement par des barrières à lumière (10) verticales par rapport à la surface du substrat dans les plans de câblage CMOS au-dessus des éléments capteurs (13) réalisés dans le substrat (15).

2.  Capteur de lumière UV selon la revendication 1, **caractérisé en ce que** les moyens de suppression de la lumière parasite sont formés au moins partiellement par le filtre (4, 5).

3.  Capteur de lumière UV selon la revendication 1 ou 2, **caractérisé en ce que** les moyens de suppression de la lumière parasite sont formés au moins partiellement par une couche métallique disposée sur toute la surface du capteur de lumière UV (1) en laissant les éléments capteurs (13) dégagés.

4.  Capteur de lumière UV selon au moins l'une des revendications précédentes, **caractérisé en ce que** les moyens de suppression de la lumière parasite sont formés au moins partiellement par des barrières à lumière (10) qui délimitent latéralement le capteur de lumière UV (1).

5.  Capteur de lumière UV selon au moins l'une des revendications précédentes, **caractérisé en ce que** les moyens de suppression de la lumière parasite sont formés au moins partiellement par un enrobage du capteur de lumière UV (1) dans un matériau opaque (11), le matériau opaque (11) entourant le bord du capteur de lumière UV (1).

6.  Capteur de lumière UV selon au moins l'une des revendications précédentes, **caractérisé en ce que** les moyens de suppression de la lumière parasite sont formés au moins partiellement par un matériau opaque (11) sur le côté arrière du capteur de lumière UV (1).

7.  Capteur de lumière UV selon au moins l'une des revendications précédentes, **caractérisé en ce que** les moyens de suppression de la lumière parasite sont formés au moins partiellement par des tranchées remplies d'un matériau opaque (11) qui délimitent latéralement l'élément capteur (13) correspondant.

8.  Capteur de lumière UV selon la revendication 1, **caractérisé en ce que** les barrières à lumière (10) verticales dans les plans de câblage CMOS sont formées par des anneaux de contact (12) fermés et/ou des bagues d'interconnexion de configuration décalée jusque dans un plan métallique supérieur du processus CMOS.

9.  Capteur de lumière UV selon au moins l'une des revendications précédentes, **caractérisé en ce que** les éléments capteurs (13) qui détectent un rayonnement sont disposés en une matrice.

10. Capteur de lumière UV selon au moins l'une des revendications précédentes, **caractérisé en ce que** des filtres (4, 5) en différents matériaux filtrants sont réalisés au-dessus des éléments capteurs (13) qui détectent un rayonnement, les filtres (4, 5) se chevauchant partiellement e/ou les deux filtres (4, 5) étant réalisés pour recouvrir partiellement la surface d'élément capteur (14) active.

11. Capteur de lumière UV selon au moins l'une des revendications précédentes, **caractérisé en ce que** les éléments capteurs (13) sont réalisés sous la forme de photodiodes et/ou de capteurs ALS et/ou de capteurs à compensation du courant d'obscurité.

12. Capteur de lumière UV selon au moins l'une des revendications 1 à 11, **caractérisé en ce que** plusieurs éléments capteurs (13) sont disposés en une matrice, les éléments capteurs (13) comprenant au moins une photodiode dotée d'un filtre à UV, un capteur ALS et une photodiode dotée d'un cache en polysilicium et d'un filtre à UV (4).

13. Capteur de lumière UV selon la revendication 12, **caractérisé en ce que** la matrice est réalisée sous la forme d'une matrice 4x4 avec sensibilité en demi-espace optimisée, composée de quatre éléments capteurs (13) différents.

14. Capteur de lumière UV selon la revendication 13, **caractérisé en ce que** la sensibilité en demi-espace optimisée est réglée par le fait que différents éléments capteurs (13) répondent aux critères d'arrangement suivants :

    - chaque élément capteur est disposé une fois dans le coin de la matrice de diodes,
    - chaque élément capteur est disposé deux fois au niveau de l'arête latérale de la matrice de diodes,
    - chaque élément capteur est disposé une fois par ligne de la matrice de diodes,
    - chaque élément capteur est disposé une fois par colonne de la matrice de diodes,
    - chaque élément capteur est disposé une fois dans les 4 sous-carrés de 2x2 de la matrice de diodes.

**15.** Procédé de détection de lumière UV avec un capteur de lumière UV selon au moins l'une des revendications précédentes, l'un ou les plusieurs éléments détecteurs (13) détectant de la lumière et délivrant un signal en réaction à celle-ci, **caractérisé en ce que**

- un premier signal de sortie d'un élément capteur, lequel est réalisé sous la forme d'une photodiode, est mesuré, **en ce que**
- un deuxième signal de sortie d'un élément capteur, lequel est réalisé sous la forme d'une photodiode avec un cache en polysilicium, est mesuré puis pondéré avec un facteur,
- une liaison mathématique entre le premier et le deuxième signal de sortie est déterminée.

**16.** Procédé selon la revendication 15, **caractérisé en ce que** la liaison mathématique calculée est la différence entre le premier et le deuxième signal de sortie.

**17.** Procédé selon la revendication 16, **caractérisé en ce que** le premier signal de sortie est formé par une part UV, une part VIS/IR et une part de courant de fuite.

**18.** Procédé selon la revendication 16, **caractérisé en ce que** le deuxième signal de sortie est formé par une part VIS/IR pondérée et une part de courant de fuite pondérée.

**19.** Procédé de détection de lumière UV avec un capteur de lumière UV selon au moins l'une des revendications 1 à 13, l'un ou les plusieurs éléments détecteurs détectant de la lumière et délivrant un signal en réaction à celle-ci, **caractérisé en ce que**

- un premier signal de sortie d'un élément capteur, lequel est réalisé sous la forme d'une photodiode, est mesuré, **en ce que**
- un deuxième signal de sortie d'un élément capteur, lequel est réalisé sous la forme d'une diode d'obscurité, la diode d'obscurité étant recouverte d'un métal opaque, est mesuré puis pondéré avec un facteur,
- une liaison mathématique entre le premier et le deuxième signal de sortie est déterminée.

**20.** Procédé selon la revendication 19, **caractérisé en ce que** la liaison mathématique calculée est la différence entre le premier et le deuxième signal de sortie.

**21.** Procédé selon la revendication 19, **caractérisé par** les caractéristiques d'au moins l'une des revendications 15 à 18.

# Fig. 1 ( Stand der Technik )

# Fig. 2 ( Stand der Technik )

## Fig. 3a (Stand der Technik)

Standard-Passivierungs-Prozess

18 · · · 4,5

17

Filter

Passivierung - $Si_3N_4$

obere Metallisierung · Passivierung - $SiO_2$ · obere Metallisierung

IMD - $SiO_2$

15

EP 3 146 568 B1

## Fig. 3b (neu)

ebene Passivierung

4,5

Filter

17

Passivierung - $Si_3N_4$

obere Metallisierung · Passivierung - $SiO_2$ · obere Metallisierung

IMD - $SiO_2$

15

Fig. 4

Fig. 5

a)

b1) Querschnitt:
UV zuerst, ALS danach

b2) Querschnitt:
ALS zuerst, UV danach

## Fig. 6a

## Fig. 6b

Einfall von Streulicht, welches auf obere Metallisierung strahlt (siehe Pfeil) und sich von da aus in Richtung UV Sensorelement lateral ausbreitet, wird reduziert

Filter

obere Metallisierung
Via
Metall
Via...

UV Sensorelement

ALS Sensorelement

UV Sensorelement

ALS optische Öffnung durch obere Metallisierung

EP 3 146 568 B1

## Fig. 7

3

13

6

1    20

2

## Fig. 8a

IR- Licht- durchlässiges Silizum

9    7

8

2    4    7

## Fig. 8b

IR- Licht-undurchlässiges Silizium

9    7

8

10    4    2

# Fig. 9

7   9

8

4

11

2

10

lichtundurchlässig

# Fig. 10

Seitenansicht    M2 [    ]
                        VIA/Kontakt (31)
                [    ] M1

Draufsicht      M2 [    □    ] M1

           VIA/Kontakt

Fotodiode   VIA/Kontakt (31)

Draufsicht

Störlicht   Diodenfläche (14)

↑ Standardprozess ohne durchgehende Kontakte
─────────────────────────────────────────────
↓ Durchgehende Kontakte

Fotodiode

12

Draufsicht

Seitenansicht

← kein Störlicht

# Fig. 11a

Empfindlichkeit

———— Fotodiode

·············· Fotodiode mit Poly

UV | sichtbar | IR | Wellenlänge

# Fig. 11b

Empfindlichkeit

———— Fotodiode + UV-Filter

– – – – Fotodiode mit Poly + UV-Filter

UV | sichtbar | IR | Wellenlänge

# Fig. 12

| | DD | UV poly | x | G | UV |
|---|---|---|---|---|---|
| | DD | UV | G | x | UV poly |
| | DD | x | UV | UV poly | G |
| | DD | G | UV poly | UV | x |

| | C | Dunkelkompensation |
|---|---|---|
| | G/ALS | Umgebungslicht |
| | UV | UV |
| | UV poly | UV VIS/IR Kompensation |
| | x | Nutzung nicht definiert |

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2007187794 A
- DE 102012001481 A1
- DE 102012001070 A1